# EUROPEAN PATENT APPLICATION

(11) **EP 3 062 116 A1**
(43) Date of publication of application: **31.08.2016**
(21) Application number: 15156703.9
(22) Date of filing: 26.02.2015
(51) Int. Cl.: G01R 22/06, G01R 22/10, G06Q 50/06

(54) **System and method for metering electric energy in a housing complex**

(71) Applicant: E.ON SE, 40479 Düsseldorf (DE)
(72) Inventor: Moldowan, Mirko, 45699 Herten (DE); Christ, Stefan, 47167 Duisburg (DE)
(74) Representative: Glawe, Delfs, Moll

(57) **Abstract**

The present invention relates to a system for metering electric energy in a housing complex (13) with a multiplicity of housing units (14, 15, 16, 17). The system comprises an internal distribution network (12) for distributing electric energy to the multiplicity of housing units (14, 15, 16, 17) and an electricity generation unit (18). The internal distribution network (12) is connected to the electricity generation unit (18) at a first connection point (19). Furthermore, the internal distribution network is connected to a public electricity grid (20) at a second connection point (21). According to the invention time-resolved meters (22, 23, 24, 25, 26) are provided which allow determining the amount of energy consumed by a housing unit (14, 15, 16, 17), the time of energy consumption and whether the energy originates from the electricity generation unit (18) or from the public electricity grid (20).

## Description

The present invention relates to a system for metering electric energy in a housing complex with a multiplicity of housing units. The system comprises an internal distribution network for distributing electric energy to the multiplicity of housing units and an electricity generation unit. The internal distribution network is connected to the electricity generation unit at a first connection point. Furthermore, the internal distribution network is connected to a public electricity grid at a second connection point.

It is known to equip buildings with electricity generation units. For instance, it is possible to arrange a photovoltaic system on the roof of a building. The electricity generated by the photovoltaic system may be consumed directly by the inhabitants of the building. Furthermore, excess electric energy may be fed into a public electricity grid in return for a remuneration. If the demand for electric energy exceeds the amount generated by the photovoltaic system, the required amount can be received from the public electricity grid.

If a photovoltaic system is installed on the roof of a housing complex comprising a multiplicity of housing units, for example on the roof of an apartment building, it has to be settled initially in which way the generated electricity is allocated to the housing units and how the housing units will benefit from a feeding of excess electricity into the public grid.

A known configuration for metering electric energy comprises a first electric meter counting the electric energy generated by the photovoltaic system, a second electric meter counting the energy received from the grid, and a third electric meter counting the energy fed into the grid. Furthermore, an electric meter is provided for each housing unit in order to count the consumption of the respective housing unit. After a certain period of time the meters are read in order to obtain aggregated energy values, such as the total energy generation, the total energy fed into the grid, the total energy received from the grid, and the total housing unit consumption of each housing unit. The total energy fed into the grid yields a total remuneration which may be distributed to the housing units such that each housing unit receives an average share of the remuneration.

It is another known approach to divide the photovoltaic system into a multiplicity of separated sub-modules and to assign a single sub-module to each housing unit. This means that each housing unit has a single sub-module at its exclusive disposal. In this case it is necessary to provide for each housing unit a first meter counting the energy generated by the sub-module, a second meter counting the energy received from the grid, a third meter counting the energy fed into the grid by the sub-module, and a fourth meter counting the housing unit consumption of the respective housing unit. The division of the photovoltaic system into sub-modules allows to determine the exact amount of photovoltaic energy consumed by a single housing unit and the exact amount of photovoltaic energy fed into the grid by a sub-module of a single housing unit. Each housing unit therefore receives a fair and appropriate remuneration exactly reflecting the electricity usage pattern of that housing unit. However, it is a major drawback that the separation of a photovoltaic system into sub-modules leads to higher installation costs due to a multiplication of electric components such as meters or wiring. Furthermore, the overall housing complex consumption of self-produced photovoltaic energy may be reduced, as it is, for instance, impossible for a first housing unit to consume the solar energy produced by a sub-module being assigned to a second housing unit. This is particularly disadvantageous in view of decreasing guaranteed feed-in remunerations.

It is the object of the present invention to provide an improved system for measuring electric energy in a housing complex which on the one hand offers the advantages and on the other hand avoids the drawbacks of the of the prior art at least partially. It is a particular object of the present invention to provide an improved system for measuring electric energy in a housing complex which allows an optimization with regard to the overall housing complex consumption of self-produced energy. The object is solved by the features of the independent claims. Preferable embodiments are to be found in the dependent claims. According to the invention the system for metering electric energy in a housing complex with a multiplicity of housing units comprises at least one time-resolved housing unit meter, wherein each time-resolved housing unit meter is assigned to a single housing unit for measuring the energy consumption of the respective housing unit. Furthermore, the system comprises a time-resolved transfer meter for measuring the energy being transferred at a connection point.

First of all a few terms used within the present invention are explained. A time-resolved meter is a meter which is capable of measuring amounts of energy transferred in a power line, wherein a measurement value is allocated to a point in time, at which the value has been measured. Thus, a time-resolved meter allows to extract information about the variation in time of the energy being transferred. For instance, a time-resolved meter may record an energy value at certain time intervals, wherein each value corresponds to the amount of energy being transferred in the power line during the time interval. A time-resolved meter has to be distinguished from usual electric meters without the capability for a time-resolved metering. Such usual electric meters are called static meters in the following. Static meters accumulate electric energy being transferred in a power line. After a period of time an aggregated total amount of energy can be read from the static meter, however, it is impossible to extract information about the variation in time of the transferred energy.

The term connection point has to be understood in a broad sense. Within the invention a connection point does not require any particular design or particular electric components. A connection point can be any point in a power line which is located between the power generation unit and the internal distribution network or between the internal distribution network and the public electricity grid.

The inventive system may comprise usual static meters counting the housing unit consumption of each housing unit, the energy generated by the electricity generation unit, the energy fed into the public grid, and the energy received from the public grid. The static meters for counting the energy fed into the public grid and for counting the energy received from the grid may be combined in a static bidirectional counter. It is possible to retrofit the features of present invention in a housing complex already having static meters. In this case it is possible to replace the existing static meters or to add the inventive features without removing the existing static meters. In particular, a connection point may coincide with the position of a static meter.

An electricity generation unit may be any device or apparatus which is capable of producing electricity. In a prevalent case of use of the present invention the electricity generation unit is a photovoltaic system mounted on the roof of the housing complex. However, the use of other electricity generation units such as a wind turbine or a biogas plant are also comprised by the inventive idea.

The inventive time-resolved housing unit meters allow determining at each point in time the amount of electric energy consumed by a housing unit. Furthermore, the inventive time-resolved transfer meter allows at each point in time to determine the amount of energy transferred into or out of the internal distribution network at a connection point. As the measured energy values are allocated to a point in time, at which the values have been measured, it is possible to combine different energy values measured at the same point in time. By doing so, it is, for example, possible to evaluate for each point in time, the share of the housing unit consumption which originates from the photovoltaic system and the share which is received from the grid.

Within the invention it has been recognized that there is the need to determine exactly which housing unit has consumed which amount of energy at which time. In particular, such information are useful to determine a fair and appropriate remuneration for each housing unit, instead of assigning an average remuneration to each housing unit. Furthermore, the invention renders possible a new way of "sharing" an electricity generation unit, as will be explained later. Furthermore, the invention does not require a physical division of the photovoltaic system into sub-modules. Therefore, fewer electric components, meters and wiring are required leading to lower installation costs.

In a preferred embodiment a time-resolved housing unit meter is provided for each housing unit of the housing complex. In this case, the sum of all energy values measured by the time-resolved housing unit meters at a certain point in time corresponds to the total energy consumption of the housing complex at that point in time.

It is expedient if the time-resolved energy values measured by the time-resolved meters can be evaluated easily and efficiently. In an advantageous embodiment, the time-resolved housing unit meter and / or the time-resolved transfer meter therefore comprise a memory, in which measured energy data and corresponding time data can be stored. Preferably, the memory is accessible by a read-out device. In this case the time-resolved meters can be read out regularly in order to evaluate the energy and time data stored in the memory. Preferably, the time-resolved housing unit meter and / or the time-resolved transfer meter comprise a sending unit for sending the measured energy data and the corresponding time data. Preferably, the sent data are received by a receiving unit. By sending the energy and time data to a receiving unit, the read out process is substantially simplified. The sending process may be conducted by a cable connection or by a wireless connection.

In a preferred embodiment, the system comprises a processing unit for processing the measured energy data and the corresponding time data of the time-resolved meters. The processing unit allows a quick and reliable automatic evaluation of the energy and time data.

In one embodiment, the time-resolved transfer meter is adapted to measure the energy being transferred at the first connection point. At the first connection point the electricity generation unit is connected to the internal distribution network. Accordingly, in this case the time-resolved transfer meter measures the energy generated by the electricity generation unit. The inventors have recognized that it is sufficient, if at each point in time the housing unit consumption of each housing unit and the energy generated by the electricity generation unit is known. In particular, the sum over the consumption of all housing units corresponds to the total consumption of the housing complex. If the energy generated by the electricity generation unit falls short of the total consumption, the energy received from the public electricity grid can be calculated. If, on the other hand, the generated energy exceeds the total consumption, the energy fed into the grid can be calculated. Accordingly, the invention enables the gathering of all necessary data with little effort.

In an alternative embodiment, the time-resolved transfer meter is adapted to measure the energy being transferred at the second connection point. At the second connection point the internal distribution network is connected to the public electricity grid. In this case, the time-resolved transfer meter therefore measures the energy received from and fed into the public grid. This configuration also enables the gathering of all necessary data in an analogous way as described above.

In a preferred embodiment, the time-resolved transfer meter is adapted to measure the difference between the energy being fed into the internal distribution network by the electricity generation unit and the energy being received from the public electricity grid.

The invention furthermore relates to a method for metering electric energy in a housing complex comprising a multiplicity of housing units, wherein the method uses a system according to the present invention. The method comprises the following steps:
- determining time-resolved housing unit consumption data,
- determining time-resolved energy transfer data at a connection point.

Preferably, the time-resolved housing unit consumption data and the time-resolved energy transfer data are evaluated by the following steps:
- assigning a 'share of generated energy' to each housing unit,
- attributing for each housing unit a proportion of the housing unit consumption to:
   o self consumption, being the proportion of the housing unit consumption which is smaller than or equal to the 'share of generated energy' of the particular housing unit, to
   o internal consumption, being the proportion of the housing unit consumption which is larger than the `share of generated energy' and which originates from the electricity generation unit, and to
   o external consumption, being the proportion of the housing unit consumption which is larger than the `share of generated energy' and which originates from the public electricity grid.

The method allows a new way of "sharing" an electricity generation unit. If, based on time resolved consumption and transfer data, a 'share of generated energy' is assigned to each housing unit, this means that the total energy generated by the generation unit at a certain point in time is allocated to the housing units according to the assigned 'share' values. Preferably, the sum of the 'share' values equals 100%. The 'share' values may by distributed between the housing units equally or unequally. The 'share of generated energy' value of a housing unit may reflect the share of ownership of the energy generation unit.

For instance, in a housing complex with four housing units, each housing unit may be assigned a 'share' value of 25 %. If, for instance, at a certain point in time the energy generation unit generates a power of 10 kW, the 'share of generated energy' assigned to each housing unit is 2.5 kW.

Furthermore, the inventive method allows to specify for each housing unit and at each point in time where the energy which is consumed by a particular housing unit originates from. In particular, it is possible to distinguish between self-consumption, internal consumption and external consumption. Self-consumption is the amount of energy consumed by a housing unit which originates from the 'share of generated energy' of that particular housing unit. If the consumption of a housing unit is, at a certain point in time, larger than its 'share of generated energy', the excess required energy may be obtained from the 'share of generated energy' of other housing units (internal-consumption) or from the external grid (external consumption).

In the above example, a first housing unit may, at a certain point in time, consume 3 kW, wherein at the same time its 'share of generated energy' is only 2.5 kW. If a second housing consumes, for instance, at the same point in time only 1.5 kW, the second housing unit may deliver 0.5 kW to the first housing unit. By doing so, the overall self-consumption can be increased by 0.5 kW (in comparison with the case in which the energy generating unit is divided into sub-modules, wherein each housing unit has a single sub-module at its exclusive disposal). The increase of the overall self-consumption is a beneficial effect of the present invention, as usually the cost of internal consumption is lower than the cost of external consumption.

In addition, it is possible for each housing unit to determine at each point in time not only the amount of electricity being consumed, but also the origin of the electricity, i.e. if the share of self-consumption, internal consumption, and external consumption.

It is further preferred that the time-resolved housing unit consumption data and the time-resolved energy transfer data are further evaluated by the following steps:
- attributing for each housing unit a proportion of the `share of generated energy' of the respective housing unit to
   o 'internal feeding' being the proportion of the `share of generated energy' which is fed into the internal distribution network and which is consumed by other housing units, and to
   o 'external feeding' being the proportion of the `share of generated energy' which is fed into the public electricity grid.

Accordingly, the method also allows to determine for each housing unit at each point in time, if the 'share of generated energy' is used internally by other housing units (internal feeding) or if it is used to be fed into the external grid. Of course 'internal feeding' and 'external feeding' values can only be obtained for a particular housing unit in case the 'share of generated energy' of this housing unit is larger than its consumption at a certain point in time. The evaluation of internal and external feeding allows to determine a fair and appropriate remuneration for each housing unit.

It is furthermore preferred to determine time-aggregated values of one or more of the following energy values: self consumption, internal consumption, external consumption, internal feeding, external feeding. For instance, it is possible to determine a one-day, one month, or a one year aggregated value for the above-noted values.

In the following the features, objects and advantages of the present invention are further described by means of an exemplary preferred embodiment referring to the accompanying drawings which show:

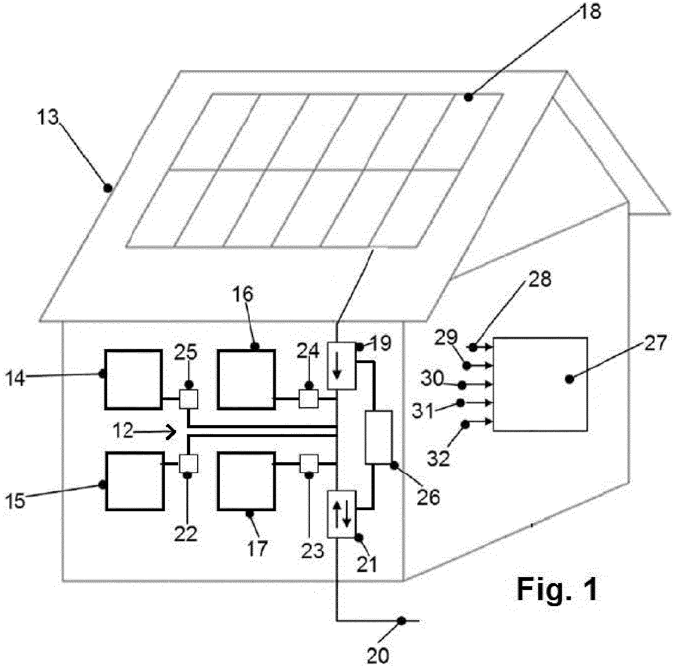

- Figure 1:: a schematic view of a housing complex in accordance with the present invention.

Figure 1 shows a schematic overview over an exemplary embodiment of an inventive housing complex 13. The housing complex 13 comprises four housing units 14, 15, 16, 17. An internal distribution network 12 is provided within the housing complex 13 in order to provide electric energy to the housing units 14-17.

A photovoltaic system 18 is arranged on the roof of the housing complex 13. The photovoltaic system 18 is connected to the internal distribution network 12 at a connection point 19. In this embodiment the connection point 19 coincides with a static meter (indicated by the down arrow in Figure 1) for counting the energy generated by the photovoltaic system 18. Furthermore, the internal distribution network 12 is connected to a public electricity grid 20 at a connection point 21. The connection point 21 coincides with a static bidirectional meter (indicated by the down and up arrows in Figure 1).

Each of the housing units 14-17 is provided with a time-resolved housing unit meter 22, 23, 24, 25. Each time-resolved housing unit meter measures in regular time intervals of 1s the energy consumption of the respective housing unit within this time interval. At the end of each time interval a combination of an energy consumption value and a time value corresponding to the absolute time at which the energy value has been measured, is stored in a memory of the housing unit meter.

Furthermore, a time-resolved transfer meter 26 is provided. The time-resolved transfer meter 26 measures in regular time intervals of 1s the difference between the energy being fed into the internal distribution network 12 by the electricity generation unit 18 and the energy being received from the public electricity grid 20. At the end of each time interval a combination of the measured energy difference and a time value corresponding to the absolute time at which the energy difference has been measured, is stored in a memory of the housing unit meter.

The time-resolved meters 22-26 comprise a sending unit for a wireless transfer of data. The sending units are not shown in Figure 1. In regular time intervals or upon request of a user, the sending units of the time-resolved meters send the respective energy and time data to a processing unit 27. The processing unit comprises inputs 28-31 for receiving the respective energy and time data from the sending units of the time-resolved meters 22-26.

The system is adapted to perform the inventive method which has been explained in detail above. In particular, it is possible to determine self consumption, internal consumption and external consumption values, as well as internal feeding and external feeding values at each point in time or aggregated on a daily, weekly, monthly or yearly basis.

## Claims

1. System for metering electric energy in a housing complex (13) with a multiplicity of housing units (14, 15, 16, 17), comprising an internal distribution network (12) for distributing electric energy to the multiplicity of housing units (14, 15, 16, 17) and an electricity generation unit (18), wherein the internal distribution network (12) is connected to the electricity generation unit (18) at a first connection point (19) and wherein the internal distribution network (12) is connected to a public electricity grid (20) at a second connection point (21), **characterized in that** the system further comprises at least one time-resolved housing unit meter (22, 23, 24, 25) each being assigned to a single housing unit (14, 15, 16, 17) for measuring the energy consumption of the respective housing unit (14, 15, 16, 17), and a time-resolved transfer meter (26) for measuring the energy being transferred at a connection point (19, 21).

2. System according to claim 1, **characterized in that** the time-resolved housing unit meter (22, 23, 24, 25) and / or the time-resolved transfer meter (26) comprise a memory, in which measured energy data and corresponding time data can be stored.

3. System according to claim 1 or 2, **characterized in that** the time-resolved housing unit meter (22, 23, 24, 25) and / or the time-resolved transfer meter (26) comprise a sending unit for sending measured energy data and corresponding time data.

4. System according to one of claims 1 to 3, **characterized in that** a processing unit (27) is provided for processing the data of the time-resolved meters (22, 23, 24, 25, 26).

5. System according to one of claims 1 to 4, **characterized in that** the time-resolved transfer meter (26) is adapted to measure the energy being transferred at the first connection point (19).

6. System according to one of claims 1 to 4, **characterized in that** the time-resolved transfer meter (26) is adapted to measure the energy being transferred at the second connection point (21).

7. System according to one of claims 1 to 4, **characterized in that** the time-resolved transfer meter (26) is adapted to measure the difference between the energy being fed into the internal distribution network by the electricity generation unit (18) and the energy being received from the public electricity grid (20).

8. Method for metering electric energy in a housing complex comprising a multiplicity of housing units, wherein the method uses a system according to claim 1 and comprises the following steps:
- determining time-resolved housing unit consumption data,
- determining time-resolved energy transfer data at a connection point.

9. Method according to claim 8, **characterized in that** the time-resolved housing unit consumption data and the time-resolved energy transfer data are evaluated by the following steps:
- assigning a 'share of generated energy' to each housing unit,
- attributing for each housing unit a proportion of the housing unit consumption to:
- self consumption, being the proportion of the housing unit consumption which is smaller than or equal to the 'share of generated energy' of the particular housing unit, to
- internal consumption, being the proportion of the housing unit consumption which is larger than the 'share of generated energy' and which originates from the electricity generation unit, and to
- external consumption, being the proportion of the housing unit consumption which is larger than the 'share of generated energy' and which originates from the public electricity grid.

10. Method according to claim 9, **characterized in that** the time-resolved housing unit consumption data and the time-resolved energy transfer data are further evaluated by the following steps:
- attributing for each housing unit a proportion of the 'share of generated energy' of the respective housing unit to
- 'internal feeding' being the proportion of the 'share of generated energy' which is fed into the internal distribution network and which is consumed by other housing units, and to
- 'external feeding' being the proportion of the 'share of generated energy' which is fed into the public electricity grid.
